# FASCICULE DE BREVET EUROPEEN

(11) **EP 1 364 400 B1**
(45) Date de publication et mention de la délivrance du brevet: **19.05.2010**
(21) Numéro de dépôt: 02708436.7
(22) Date de dépôt: 01.03.2002
(51) Int. Cl.: H01L 21/762

(54) **PROCEDE DE FABRICATION DE COUCHES MINCES SUR UN SUPPORT SPECIFIQUE ET UNE APPLICATION**
HERSTELLUNGSVERFAHREN FÜR DÜNNE SCHICHTEN AUF EINEM SPEZIFISCHEN SUBSTRAT UND ANWENDUNG
METHOD FOR PRODUCING THIN LAYERS ON A SPECIFIC SUPPORT AND AN APPLICATION THEREOF

(30) Priorité: 02.03.2001 FR 0102890
(43) Date de publication de la demande: 26.11.2003
(73) Titulaire: Commissariat à l'énergie atomique et aux énergies alternatives, 75015 Paris (FR)
(72) Inventeur: ASPAR, Bernard, F-38140 Rives (FR); CLERC, Jean-Frédéric, F-38320 Brie et Angonnes (FR)
(74) Mandataire: Quantin, Bruno Marie Henri
(86) Numéro de dépôt international: PCT/FR2002/000754
(87) Numéro de publication internationale: WO 2002/071475

(56) Documents cités:
- EP-A- 0 767 486
- EP-A- 0 786 801
- EP-A- 1 014 452
- WO-A-01/11930
- US-A- 5 300 788
- PATENT ABSTRACTS OF JAPAN vol. 1999, no. 13, 30 novembre 1999 (1999-11-30) -& JP 11 233449 A (DENSO CORP), 27 août 1999 (1999-08-27)

## Description

Les futurs systèmes portatifs (par exemple téléphones portables, cartes à puces ou encore assistants personnels du futur) intègreront de plus en plus de fonctions. La réalisation de ces systèmes comme par exemple les assistants personnels du futur utiliseront de nombreuses « briques » technologiques. Parmi ces briques technologiques, on trouve : les écrans, le système d'exploitation, le microprocesseur, les batteries. Parmi ces composants, les écrans sont ceux qui occupent le plus de surface et leur intégration dans le système est un point important.

Le développement en masse de ces objets ne se réalisera que si le coût de ces composants diminue. Il est nécessaire pour cela d'avoir des technologies compatibles avec des grands volumes qui permettent de réaliser ces composants sur des supports de grande dimension comme par exemple le verre. Cependant, bien que ce support soit de faible coût, il a un principal défaut qui est sa tenue au choc. Les composants ou dispositifs réalisés sur ces supports nécessitent alors l'utilisation de protections supplémentaires pour pouvoir les intégrer dans les systèmes portatifs.

Or, pour que l'intégration de ces composants soit maximale, il apparaît intéressant d'intégrer ces composants sur le support définitif. Dans de nombreux cas, ce support peut être avantageusement en plastique. Un des défis est d'obtenir par exemple des écrans sur un support plastique qui associe à la fois un bas coût, un faible poids et une bonne solidité aux chocs (au moins en comparaison à du verre). Cette application est particulièrement intéressante pour les téléphones portables de nouvelle génération.

Pour les systèmes portatifs, comme par exemple les cartes à puces, il est en outre nécessaire d'avoir des composants de faible épaisseur, pour des problèmes de poids et de souplesse (pour s'adapter à celle de la carte à puce).

### Problème à résoudre

La réalisation de ces composants sur un support tel que le plastique est un problème délicat. En effet, il faut, soit modifier toute la technologie de réalisation de ces composants pour qu'elle soit compatible avec du plastique classique, soit trouver des supports « plastiques » spéciaux qui soient compatibles avec les traitements thermiques de la technologie (il est clair que, notamment, il ne faut pas, en pratique, atteindre le point de ramollissement de ces supports.

Une autre approche consiste à réaliser les composants (circuits intégrés, écrans, composants passifs), sur un substrat compatible avec les technologies existantes et de les reporter sur leurs supports définitifs,

De telles technologies sont décrites dans les documents EP-A-1 014 452 et US-A-5,606,186.

Cette approche présente l'intérêt de permettre la réalisation de certains composants sur des supports à bas coût avec des technologies souvent plus simples que les technologies standards de la microélectronique. On peut citer par exemple les technologies utilisées pour la réalisation d'écrans plats, comme par exemple les transistors en films minces connus sous le sigle TFT, réalisés en silicium amorphe ou poly-cristallin. Ces technologies sont réalisées sur des supports qui sont généralement en verre.

Différentes techniques peuvent être utilisées pour reporter des couches d'un support vers un autre support. On peut citer par exemple les techniques publiées en 1985 par T. Hamaguchi et al.- Proc. IEDM 1985 p. 688. Ces techniques présentent un grand intérêt car elles permettent de transférer de manière efficace une couche d'un substrat vers un autre substrat mais elles nécessitent la consommation du substrat de base (détruit au cours du procédé), et ne permettent pas le transfert homogène du film mince (c'est à dire avec une épaisseur constante en tout point) sauf si une couche d'arrêt est présente pour empêcher la consommation du substrat.

Plus récemment, d'autres techniques ont été présentées pour reporter des transistors TFT (réalisés en poly silicium sur un support en verre) sur des supports en plastique. Ref. S. Utsunomiya et al. - Proc. IDS 2000 p. 916 ou brevet EP 0 924 769 AI de Seiko. Ces méthodes sont basées sur la création d'une couche de séparation (généralement en silicium amorphe) sur un support, qui après réalisation de composants sur cette couche, permet la séparation et le report sur un autre support. Dans ce cas, la séparation (ou exfoliation) est obtenue à l'aide d'une irradiation avec de la lumière (typiquement un faisceau type laser). Une telle irradiation est cependant difficile à maîtriser pour les grandes surfaces. En effet, une inhomogénéité d'illumination peut entraîner une exfoliation non homogène, ce qui peut conduire à une détérioration du film superficiel. Ceci présente un handicap technologique non négligeable.

Parmi les procédés de report, il est également possible d'utiliser les méthodes de transfert de couches minces de matériaux contenant, ou pas, tout
ou partie d'un composant microélectronique. Ces méthodes sont basées sur la création d'une couche fragile enterrée dans un matériau à partir de l'introduction d'une ou plusieurs espèces gazeuses. On peut se référer aux documents US-A-5374564 (ou FR-A-2681472 ou EP-A-533551), US-A-6 020252 (ou FR-A-2748851 ou EP-A-807970), FR-A-2767416 (ou EP-A-1010198), FR-A-2748850 (ou EP-A-902843) ou FR-A-2773261 (ou EP-A-963598) qui présentent ces procédés.

Ces procédés sont généralement utilisés avec l'objectif de détacher l'ensemble d'un film d'un substrat initial pour le reporter sur un support. Le film mince obtenu contient alors une partie du substrat. Ces films peuvent servir de couches actives pour la réalisation de composants électroniques ou optiques. En effet, le principal intérêt de ces procédés est qu'ils permettent d'obtenir des films minces de substrats mono cristallins sur des supports différents. Ces films peuvent contenir tout ou partie d'un composant.

Par contre, avec ces procédés, il est difficile d'obtenir la séparation d'une couche mince dans certains supports tels que par exemple le verre, la silice fondue, les céramiques, certains polymères et certains matériaux amorphes, ... ; pour obtenir la séparation, il faudrait se mettre dans des conditions expérimentales extrêmes : très forte dose d'implantation et/ou énergie mécanique de séparation importante, ... difficilement envisageables en pratique, à l'heure actuelle.

Or, le verre est un support qui présente de nombreux avantages. Il est peu cher, il existe en grande dimension, il est facilement manipulable. C'est un support qui est très utilisé pour réaliser des composants comme les matrices actives et circuits de lecture pour écrans plats, les filtres couleur et même certains composants passifs (R, L, C).

L'invention a ainsi notamment pour objet de prelever individuellement des composants réalisés sur ce type de support et de les reporter sur un autre support (par exemple plastique) ou sur un autre substrat sans avoir à créer de couche fragile dans le premier support, en sorte de prélever les composants sur lequel ils sont réalisés.

Plus généralement l'invention a pour objet un procédé qui permet de reporter des composants ou dispositifs réalisés sur de premier et second supports vers un autre support sans présenter les inconvénients de toutes les méthodes précédentes (consommation du support, inhomogénéité de transfert, spécificité du substrat). En particulier, l'invention vise à pouvoir récupérer des composants ou dispositifs normalement réalisés sur des supports qui ne permettent pas d'obtenir facilement une couche enterrée fragilisée (après récupération du film contenant tout ou partie des composants, le support peut être recyclé et réutilisé), ainsi qu'à pouvoir réaliser un transfert très homogène sur des grandes dimensions (quelques dizaines de centimètres).

### Présentation de l'invention

L'invention propose à cet effet un procédé selon la revendication 1.

L'invention permet ainsi de réaliser une séparation d'une pluralité de composants au sein d'une couche mince, vis-à-vis de supports librement choisis en fonction de divers critères liés à la préparation de ce composant, sans avoir à prévoir de réaliser cette séparation dans ces supports.

L'invention s'applique plus particulièrement aux supports qui ne permettent pas d'obtenir facilement une couche fragilisée pour une séparation ultérieure. C'est ainsi que l'invention s'applique notamment au cas où le support est en matériau semi-conducteur ou en verre ou en silice fondue (d'autres matériaux présentent le même handicap, notamment les céramiques, certains polymères et certains matériaux amorphes....., voir ci-dessus), ou à des supports qui permettent la séparation dans des conditions plus difficiles que celles que leur autorise la présence de la couche rapportée.

L'invention s'applique tout particulièrement au cas où l'on souhaite obtenir les composants au sein d'une couche mince de grandes dimensions (ce qui suppose bien sûr que le support ait au moins les mêmes dimensions), auquel cas on doit utiliser en pratique un support ayant une bonne tenue mécanique, notamment une bonne rigidité.

La couche rapportée peut être de natures diverses. Elle est par exemple réalisée en silicium (cas préféré), voire en germanium ou en un alliage de silicium et de germanium. Lorsque cette couche est en silicium, celui-ci peut être de préférence polycristallin, moins onéreux que le silicium monocristallin.

Cette partie fragilisable est avantageusement réalisée par dépôt puis par recristallisation. Mais elle peut être réalisée par d'autres procédés comme dans US-5 374 564.

Cette partie fragilisable a typiquement une épaisseur d'au moins de l'ordre de 50 nanomètres, et de préférence inférieure à de l'ordre de 1000 nanomètres : cela contribue à obtenir une bonne planéité de la surface inférieure de la couche mince.

Une couche d'accrochage est éventuellement disposée entre le support et la partie fragilisable. C'est ainsi que, lorsque le support est en verre ou en silice fondue et que la partie fragilisable est en silicium, il y a éventuellement une couche d'accrochage en oxyde de silicium.

Selon une autre caractéristique avantageuse de l'invention, la couche rapportée comporte, sur la partie fragilisable, une couche supplémentaire qui reçoit le composant (ou au moins une partie de celui-ci) ayant une nature identique ou similaire (du point de vue composition et propriétés mécaniques, chimiques, etc.) à celle du support. Lorsque ce support est en verre ou en silice fondue, cette couche supplémentaire est avantageusement en oxyde de silicium.

Cette couche supplémentaire peut être ajoutée avant ou après l'étape de fragilisation.

Ainsi selon cette caractéristique de l'invention, on réalise la couche de fragilisation à l'intérieur d'un « quasi-substrat » (elle est prise en sandwich entre deux matériaux identiques ou très similaires) ; ce dernier présente tous les avantages d'un support (par exemple : état de surface, rigidité d'ensemble dans le cas du verre) tout en étant facilement compatible avec la réalisation d'une couche fragilisée par introduction d'espèces gazeuses dans la couche prise en sandwich. Ce « quasi-substrat » permet de réaliser des composants ou dispositifs sur un support incompatible avec une séparation facile, et de les dissocier ensuite sans difficulté pour un report sur un autre support.

La couche supplémentaire a de préférence une épaisseur de l'ordre de 300 nanomètres à 10000 nanomètres, suffisamment faible pour permettre le traitement de fragilisation, mais suffisante pour être significative et permettre une bonne réalisation du (ou des) composant(s), au moins en partie, et/ou permettre que la couche mince soit autoportée et/ou permettre d'éviter l'apparition de cloques au cours des étapes de réalisation des composants, de fragilisation ou de séparation. En d'autres termes cette couche supplémentaire, située entre la couche fragilisable et les composants, peut servir de raidisseur pour la couche mince obtenue. Cela permet également que la couche mince puisse être manipulée avant le report sur un support définitif sans qu'un support temporaire soit nécessaire.

Cette couche supplémentaire a de préférence une épaisseur supérieure à celle de la couche fragilisable (pour les raisons précitées à propos de l'épaisseur de cette couche fragilisable et à propos de la couche supplémentaire).

De façon avantageuse, on peut prévoir sous la couche supplémentaire (entre cette couche supplémentaire et la couche fragilisable) une troisième couche qui permet d'assurer une compatibilité entre la couche comportant les composants et le support définitif. Cette troisième couche est par exemple une couche de Si3N4. Dans ce cas, on enlève après fracture au niveau de la zone fragilisée, la partie résiduelle de la couche rapportée pour dégager la couche de Si3N4.

L'étape de fragilisation comporte avantageusement l'application d'un traitement thermiquement activable. Plus particulièrement ce traitement comporte de préférence l'introduction, en profondeur dans la couche fragilisable, d'éléments dont la diffusion peut ensuite, en fonction des conditions thermiques, provoquer la fragilisation voulue.

Ainsi, selon une caractéristique avantageuse de l'invention, la zone fragile est créée par l'introduction d'espèces gazeuses choisies préférentiellement parmi l'hydrogène et/ou l'hélium et/ou les gaz rares. L'usage de l'hydrogène est particulièrement bien approprié ; on peut ici se référer aux documents US-A-5374564 (ou FR-A-2681472 ou EP-A-533551), US-A-6 020252 (ou FR-A-2748851 ou EP-A-807970), FR-A-27857416 (ou EP-A-1010198), FR-A-2748850 (ou EP-A-902843) ou FR-A-2773261 (ou EP-A-963598).

Dans ce cas de traitement thermiquement activable, l'étape de séparation comporte de préférence un apport spécifique d'énergie thermique.

Pour être vraiment efficace, cet apport a de préférence pour effet d'apporter au moins la partie fragilisable à un budget thermique supérieur au budget thermique déjà fourni durant l'étape de fabrication des composants.

Le traitement de séparation peut comporter un apport d'énergie mécanique (au sens le plus large du terme, c'est à dire sous la forme de forces appliquées ou de contraintes induites dans la structure mais aussi sous forme pneumatique, par exemple par injection de gaz etc...) utilisé en combinaison avec l'apport d'énergie thermique précédent ou seul.

On obtient une séparation localisée sur une zone dont la taille correspond à celle d'un dispositif (ou d'un nombre entier de dispositifs).

De manière préférée le procédé de l'invention a pour objet de réaliser un ensemble d'éléments actifs ou passifs devant par la suite contribuer conjointement à une même fonction ; un tel ensemble est classiquement appelé « dispositif ». A titre d'exemple, un dispositif peut contenir un composant optique, optoélectronique, électronique, des filtres colorés ou un capteur mécanique, chimique et/ou biologique... Ce peut être également une matrice active avec son circuit d'adressage (cas d'un écran plat). Un dispositif comprend donc en principe plus d'un composant ; et les composants présents au sein d'une couche ne sont donc pas nécessairement identiques.

C'est ainsi que l'on peut distinguer plusieurs cas particuliers (non exclusifs) selon que l'étape de fabrication comporte la fabrication :
- d'un composant optique ou optoélectronique,
- et/ou d'un composant électronique,
- et/ou d'un capteur mécanique, chimique ou biologique.

Un cas d'intérêt particulier est celui où l'étape de fabrication comporte au moins la fabrication d'au moins une matrice active et de son circuit d'adressage, adaptés à être ensuite intégrés au sein d'un écran plat.

Le procédé de l'invention peut comporter également, après l'étape de travail, une étape de couverture selon laquelle on dépose une couche de protection sur la couche rapportée comportant les composants. Cette couche de protection, au moins dans le cas d'une couche rapportée en silicium et/ou d'une couche supplémentaire en oxyde de silicium, est de préférence en nitrure de silicium, Si3N4. Cette couche de protection peut servir à assurer la compatibilité avec un support final (en évitant par exemple la dégradation des composants sur un support plastique).

Un report des composants peut avoir lieu sur un support final (ou sur plusieurs supports finaux, lorsque la couche mince n'est pas destinée à un seul support final).

Le support final est avantageusement en un matériau différent de celui du support de départ. En particulier, le support final peut être en une matière incompatible avec les conditions thermiques de l'étape de travail ou celles de l'étape de séparation ; cela ouvre très largement le choix pour ce support final. Il peut ainsi, de manière avantageuse, être en une matière plastique, par exemple transparente, dont la température de ramollissement peut être inférieure à la température maximale de l'étape de travail (ce support ne résisterait donc pas à cette étape) ; cela correspond à un cas tout à fait intéressant en pratique.

A cet égard, l'invention couvre l'application particulière du procédé à la réalisation des écrans plats.

Il est à noter que le support final peut avoir des dimensions différentes de celles du support de départ, et donc de la couche mince obtenue (plus grandes ou plus petites, selon les besoins).

Un autre cas d'intérêt particulier est celui où le support final est une carte à puce ou une partie d'un téléphone mobile voire le polariseur en plastique d'un écran souple autoporté.

Il est important de noter ici que chaque composant peut être individuellement fixé à un support final spécifique, par exemple une carte à puce , en étant détaché du reste de la couche mince (ce commentaire vaut aussi pour le cas où l'étape de fabrication consiste à réaliser une pluralité de lots de composants complémentaires : chaque lot peut être déposé individuellement).

Un tel support peut servir à la génération d'efforts mécaniques au niveau de la couche fragilisée pour dissocier un composant de la couche mince vis-à-vis du substrat.

La fixation du (ou des) composant(s), avec le reste, ou non, de la couche mince, peut être réalisé par tout moyen, en particulier par collage au moyen d'un adhésif, ou encore par adhésion moléculaire.

Des objets, caractéristiques et avantages de l'invention ressortent de la description qui suit, donnée à titre d'exemple illustratif non limitatif, en regard des dessins annexés sur lesquels :
- la figure 1 est une vue schématique en coupe d'un support sur lequel ont été déposées, lors d'une étape de préparation, une couche de compatibilité (d'accrochage) puis une couche rapportée en deux parties,
- la figure 2 est une vue de ce support après une étape de fragilisation,
- la figure 3 est une vue de ce support après une étape de fabrication de composants,
- la figure 4 est une vue de ce support après une étape de dissociation,
- la figure 5 est une vue d'un support analogue après une étape de liaison à un support ,
- la figure 6 est une vue de ce second support après une étape de dissociation,
- la figure 7 est une vue de la couche mince résultant de l'étape de la figure 6, après une étape de report partiel
- la figure 8 est une vue en coupe d'une plaque de verre sur laquelle a été rapportée une couche en deux parties,
- la figure 9 est une vue de cette plaque après réalisation d'un premier type de composants,
- la figure 10 est une vue d'une plaque similaire à celle de la figure 8 après réalisation d'un second type de composants,
- la figure 11 est une vue des deux plaques des figures 9 et 10 après dissociation partielle et fixation dans une configuration tête-bêche,
- la figure 12 est une vue en coupe selon la ligne XII-XII de la figure 11,
- la figure 13 est une vue visualisant une étape de découpe de la plaque inférieure,
- la figure 14 est une vue en coupe selon la ligne XIV-XIV de la figure 13,
- la figure 15 est une vue de l'ensemble après la découpe des figures 13 et 14 et report sur un support plastique, avec l'indication de la trace d'une étape de découpe de la plaque supérieure,
- la figure 16 est une vue d'un composant après cette découpe et report d'un second support plastique, et
- la figure la figure 17 est une vue en coupe de ce composant.

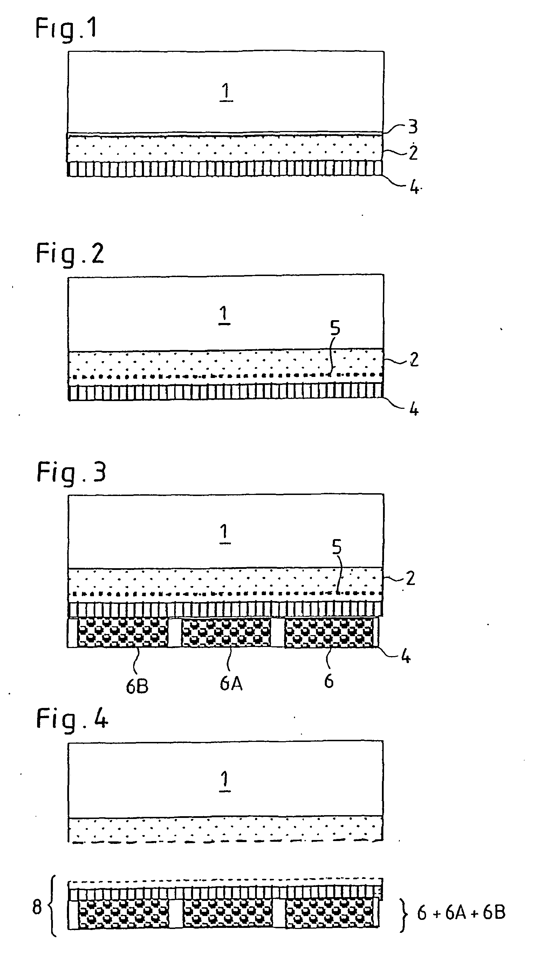

Les figures 1 à 4 représentent de manière générale un exemple de mise en oeuvre du procédé de l'invention.

On prend une plaque de verre 1 de grande dimension telle que celles utilisées par exemple pour la fabrication des écrans LCD. Il s'agit par exemple du verre portant la référence 1737 de chez CORNING.

On dépose une couche 2 de silicium amorphe, par exemple de 300 nm d'épaisseur, que l'on recristallise, par exemple à l'aide d'un faisceau laser de façon à obtenir du silicium poly cristallin appelé encore poly silicium. Comme cela apparaître plus loin, cette couche 2 est fragilisable. On peut reporter du silicium monocristallin mais cela est moins intéressant sur le plan économique.

Dans certains cas, avant de créer cette couche spécifique destinée à permettre la dissociation d'une couche mince, on peut déposer sur le support une couche intermédiaire 3 favorisant l'adhérence. Cette couche de compatibilité 3 peut être par exemple une couche d'oxyde de silicium. L'épaisseur de cette couche est exagérée à la figure 1 pour la rendre visible ; cette épaisseur peut être d'à peine 10 nanomètres.

On peut également obtenir la couche de poly silicium par dépôt de type CVD à une température par exemple de 550°C. Cette variante peut être préférée à la précédente si le support est en silice fondue et si le support supporte des températures de l'ordre de la température du dépôt. A noter que dans le procédé de l'invention, on peut également utiliser un support dont le prix est élevé car, suivant un mode de réalisation, on pourra recycler ce support (il n'est pas consommé).

Dans l'exemple représenté, on dépose ensuite, par exemple, une couche 4 d'oxyde de silicium de quelques centaines de nanomètres (par exemple 800 nm) pour se retrouver avec une surface libre de type SiO2 proche de celle du verre initial. On obtient alors un quasi substrat 1+2+4 où 1 et 4 correspondent à des matériaux très voisins.

Comme cela est schématisé à la figure 2, on génère dans la couche 2 une sous-couche fragile 5. Pour ce faire on applique un traitement qui peut être ensuite thermiquement activable. De manière préférée on introduit des ions ou des éléments gazeux (cela revient au même dans la mesure où les ions les plus légers sont des ions d'élément gazeux) en profondeur dans la couche de poly silicium de façon à créer une couche fragilisée où se fera ultérieurement la dissociation. Par exemple, on implante de l'hydrogène avec une dose de l'ordre de 7E16H+/cm² et une énergie de 100 keV.

Ces traitements de séparation seront adaptés en fonction des étapes de fragilisation (dose d'implantation, énergie, température d'implantation...).

On peut rajouter un dépôt d'oxyde de silicium de 3 micromètres d'épaisseur (cela revient donc dans l'exemple considéré à épaissir la couche 4) de façon à obtenir une structure autoportée après dissociation. Cette couche va servir de raidisseur dans le procédé de fabrication de couche mince.

Ensuite, sur la surface de SiO2, on vient réaliser (voir la figure 3) tout
ou partie d'un dispositif, c'est à dire au moins un composant 6 (il y en trois à la figure 3 notés 6, 6A et 6B qui peuvent former conjointement un dispositif). Cette étape est conduite dans des conditions classiques, telles qu'on sait les réaliser sur un support entièrement en verre.

Dans le cas où l'on veut un écran plat en final, le dispositif peut être constitué des transistors unitaires de la matrice d'active et de son circuit d'adressage. Typiquement, cette technologie ne fait pas intervenir de température supérieure à environ 400°C.

Un traitement de séparation (il est poussé jusqu'à dissociation) est ensuite réalisé pour induire le report - voir la figure 4. Typiquement, cette étape peut contenir un traitement thermique et/ou un traitement mécanique. Dans certains cas, cette séparation peut être initiée par un premier moyen (par exemple thermique) et ensuite propagé jusqu'à dissociation, par exemple par clivage, par un second moyen (par exemple mécanique). En variante, on peut aussi, par exemple, réaliser un traitement thermique à environ 450°C pendant plusieurs minutes pour obtenir la séparation puis la dissociation dans le cas où toutes les couches peuvent supporter le traitement thermique. Les conditions de séparation et dissociation dépendent, comme on le sait, fortement des conditions d'implantation.

On obtient alors des dispositifs ou composants 6 qui sont séparés de leur support de fabrication 1+2. La couche mince qui est ainsi obtenue est désignée sous la référence 8. Les espaces entre les composants peuvent être occupés par une matière de protection.

Par séparer, on entend que les dispositifs peuvent être toujours en contact avec le support mais avec une énergie de liaison très faible (par exemple des forces de maintien électrostatiques). Quant à la dissociation elle implique une séparation complète, jusqu'à ce que la couche mince 8 soit complètement indépendante de son support.

Dans la mesure où il a été indiqué ci-dessus que la couche supplémentaire 4 était dimensionnée pour pouvoir servir de raidisseur, la couche mince est autoportée et sa manipulation ne nécessite pas de raidisseur additionnel. Les composants peuvent donc être reportés sur un support final (non représenté).

Toutefois, même si la couche mince peut être considérée comme autoportée, on peut préférer faire adhérer le dispositif ou les composants 6 à un support intermédiaire qui permettra de le(s) manipuler plus facilement jusqu'à son(leur) support final. Pour obtenir une telle adhésion, on peut utiliser tout moyen tel que : ajout de matière, par exemple de la colle, ou des moyens mettant en oeuvre des préparations de surface (adhésion moléculaire notamment).

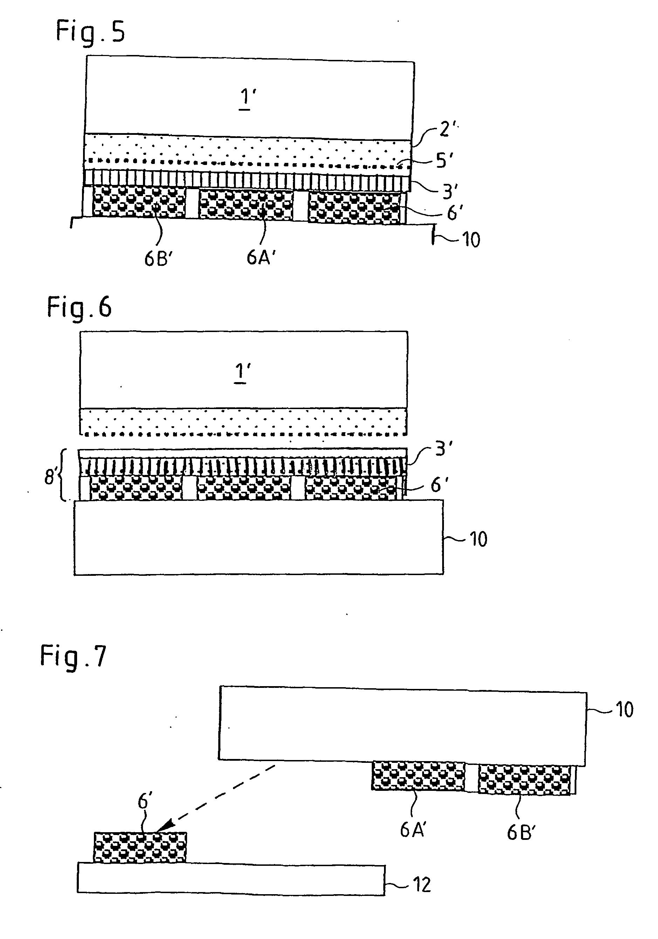

C'est ainsi que la figure 5 représente un substrat analogue à celui de la figure 3, c'est à dire comportant une couche de verre 1', une couche fragilisable 2' (avec une éventuelle couche de compatibilité 3') et une couche supplémentaire 4' sur laquelle ont été fabriqués des composants 6', 6A' et 6B'. Il y a avantageusement eu en outre dépôt d'une couche de protection non représentée. Avant de procéder à la dissociation de la couche mince, on fixe les composants à un support 10. Après dissociation (voir figure 6) le support 10 facilite la manipulation des composants.

C'est ainsi qu'à la figure 7 on voit le support dont le composant 6' a été reporté, individuellement, sur un support final 12, en étant détaché du reste de la couche mince

Une autre option consiste à vouloir mettre les composants directement en contact avec leur support final. Dans ce cas les composants sont destinés à rester sur le support.

Bien entendu le support 10 peut ne pas avoir la même composition ni les mêmes propriétés selon qu'il sert de support temporaire ou définitif.

Dans le cas où l'on utilise un support intermédiaire, l'adhésion peut être contrôlée de telle sorte que cette adhésion soit réversible. Ainsi, après solidarisation du dispositif à son support final, on peut enlever le support intermédiaire.

Il est à noter que l'on peut mettre en oeuvre un procédé tel que décrit dans les documents connus de l'état de la technique, c'est à dire en particulier que le contrôle des forces de collage est obtenu par le contrôle de la rugosité de surface ou de l'hydrophilie.

Après report du dispositif sur le support définitif, on peut le compléter en réalisant des étapes technologiques classiques qui sont compatibles avec le support définitif.

Dans une variante du procédé, après la réalisation du dispositif (6'+6A'+6B'), la dissociation est obtenue à l'aide d'un traitement thermique complété par l'utilisation de forces mécaniques (par exemple introduction d'une lame, utilisation d'un fluide liquide ou gazeux, ...) ; le support intermédiaire 10 peut contribuer à générer les forces au sein de la sous-couche fragile, par exemple par l'application d'efforts de torsion.

Une telle dissociation peut être obtenue lorsque la couche fragile enterrée a été obtenue grâce à une implantation d'hydrogène (6E16 H+/cm2 à 100keV). Après réalisation du dispositif, par exemple à une température inférieure à 300°C, on réalise un traitement thermique à 450°C durant 30 minutes de façon à obtenir une importante fragilisation au niveau de la zone fragile. Cette fragilisation faisant intervenir un phénomène activé thermiquement, il existe un couple temps-température pour chaque condition d'implantation (énergie, dose).

Finalement, on termine mécaniquement la dissociation.

Dans les exemples précités, la couche fragilisable est en silicium. En variante, cette couche fragilisable peut également être en Germanium, en SiGe, ou tout autre matériau fragilisable par implantation d'ions (par exemple semiconducteur mono ou polycristallin).

On peut donc appliquer le procédé de l'invention pour reporter un dispositif (entièrement réalisé sur un premier support) sur un second support, par exemple de type plastique. Ainsi on peut réaliser entièrement un écran LCD par des moyens classiques et le reporter en final sur un support plastique qui peut être avantageusement souple.

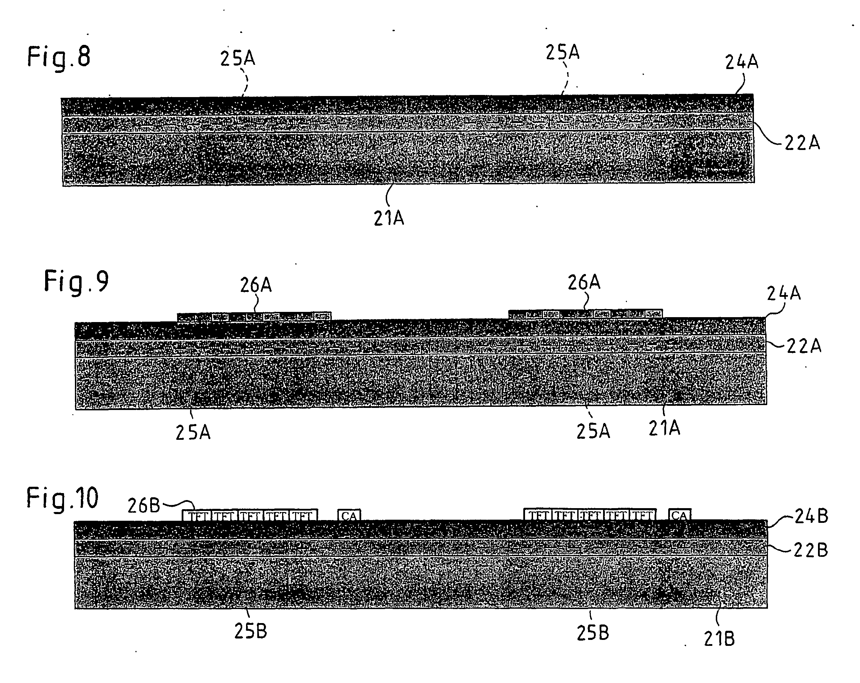

Les figures 8 à 17 visualisent la fabrication d'une pluralité de tels composants LCD individuels.

En résumé, pour ce faire, on prend deux plaques de verre, ce qui est classique pour réaliser des écrans plats : une plaque sur laquelle on va réaliser les transistors de la matrice active et le circuit d'adressage, et une plaque sur laquelle on réaliser les filtres couleur. On assemble les deux parties, on finit l'écran et ensuite, on élimine le support en verre et on reporte l'écran sur le support final. Dans une variante du procédé, après report sur le support final, l'écran peut être terminé.

La figure 8 montre l'une, 21A, des plaques de départ (le même traitement est appliqué à l'autre plaque 21 B). On dépose sur chaque plaque une couche rapportée comportant une couche fragilisable 22A (ou 22B) et une couche supérieure 24A (ou 24B) apte à servir de raidisseur.

De façon avantageuse cette couche fragilisable est en silicium polycristallin (par exemple 200 nm). De façon préférentielle, cette couche peut être d'une épaisseur plus faible (100 nm) de façon à localiser la fracture dans cette couche très mince. Puis on crée dans cette couche une zone fragile devant permettre ultérieurement la dissociation au niveau de cette zone.

Dans le cas considéré ici où, sur la même plaque, plusieurs dispositifs doivent être réalisés, il est avantageux de créer les zones fragiles uniquement au niveau des futurs dispositifs. L'objectif est ainsi d'obtenir une zone qui sera séparée du support au niveau des composants et maintenue sur la plaque par les espaces entre les dispositifs (sans zone fragile). Ces zones fragiles sont désignées sous les références 25A et 25 B sur les première et seconde plaques, aux figures 8 (et 9) et 10 respectivement.

Pour créer la zone fragile, on introduit des espèces gazeuses, par exemple par implantation d'ions hydrogène et/ou hélium. Si on prend des ions hydrogène, on peut choisir une dose comprise entre3E16 H+/cm² et 1E17 H+/cm². La localisation de la zone fragile au niveau des futurs dispositifs peut être réalisée par exemple en masquant les zonez à ne pas implanter.

La couche 24A ou 24B formant raidisseur, par exemple une couche d'oxyde, peut n'être déposée qu'après cette implantation. Elle sert à obtenir la séparation sans avoir formation de cloques. On se trouve alors dans les conditions où la couche est autoportée (voir FR-A-2738671).

Par exemple on peut déposer une couche d'oxyde de silicium de quelques microns d'épaisseur, par exemple 5 microns ou même déposer une couche mince de verre fin (par exemple de 30 microns).

Sur ces plaques ainsi préparées, on réalise toutes les étapes permettant d'obtenir la matrice active ou le filtre couleur nécessaire au composant LCD. La figure 9 montre la plaque 21A sur laquelle les éléments du filtre couleur 26A ont été réalisés, tandis que la figure 10 montre la plaque 21 B sur laquelle les éléments de la matrice active 26B ont été réalisés (il s'agit de transistors TFT (Thin Film Transistors en anglais) et d'un élément CA (pour Circuit d'Adressage)).

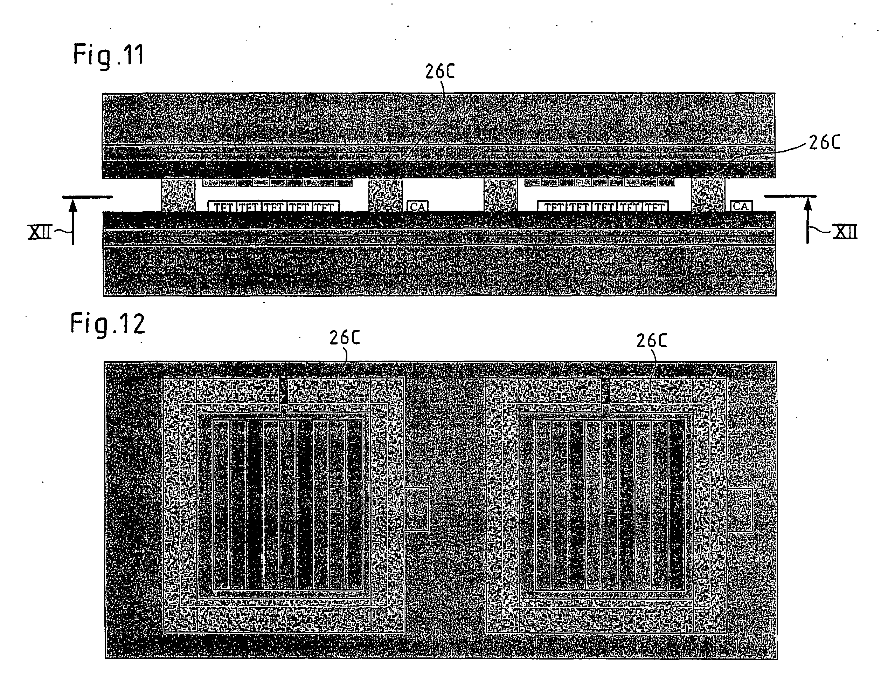

Ensuite on réalise un traitement permettant de séparer, au niveau de la zone implantée localement, la couche mince avec une partie de son dispositif du support ou pseudo-support. Par exemple ce traitement est un traitement thermique avec une température dans la gamme des 450 °C de façon à obtenir une séparation locale ou une très forte fragilisation permettant une séparation ultérieure à l'aide de forces mécaniques. A la figure 11, les zones de dissociation se distinguent des zone fragilisées des figures 9 et 10 par le fait qu'elles sont représentées par des traits continus.

Ces deux plaques sont ensuite, avec leurs composants, assemblées selon un procédé classique, à l'aide d'un cordon de colle. Dans le cas où ce cordon est compatible avec les conditions de la dissociation, la dissociation locale peut avoir lieu après assemblage

A la figure 11, on voit les deux plaques qui sont montées tête-bêche avec une entretoise 26C entourant à la fois chaque groupe de transistors TFT et chaque filtre couleur.

Ensuite on réalise les étapes classiques pour réaliser un écran LCD, c'est à dire : remplissage par du cristal liquide et scellement (voir la figure 12).

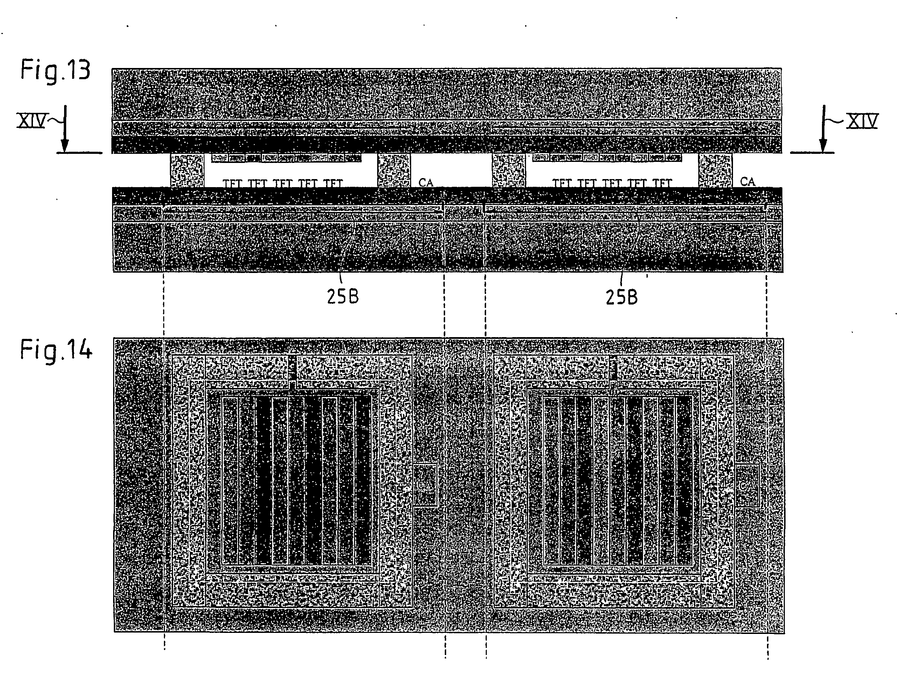

Ensuite, ainsi que cela est visualisé aux figures 13 et 14, on procède à la découpe de la plaque inférieure, aux dimensions voulues, par la technique classique de découpe au diamant (« scribe and break » en anglais). Le support de verre se sépare alors du reste du composant car il est alors séparé verticalement (par la dissociation précitée) et latéralement (par la découpe précitée). Il peut être nécessaire d'exercer un effort mécanique pour obtenir une dissociation complète au niveau de la zone fragilisée.

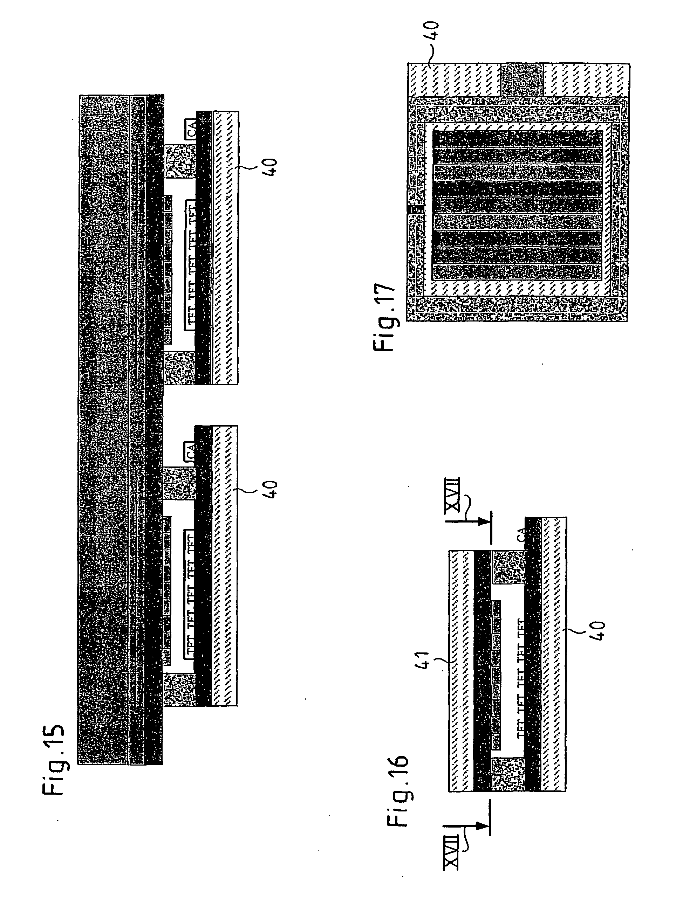

De façon avantageuse, on peut éliminer tout ou partie de la couche de silicium polycristallin avant le report sur le substrat final. Dans l'exemple représenté à la figure 15, la totalité de la partie résiduelle de ce silicium polycristallin a été ainsi éliminée avant le collage du composant sur le support définitif, ici un support plastique 40. De façon avantageuse, le support en plastique peut être le polariseur. L'épaisseur de celui-ci peut être choisie en fonction de l'application visée.

Ensuite on répète l'opération de découpe à propos de la plaque supérieure (figure 15) pour obtenir finalement (voir les figures 16 et 17) un écran LCD entre deux polariseurs 40 et 41 sans la présence du verre qui a servi à son élaboration.

## Revendications

1. Procédé de fabrication d'une couche mince comportant au moins un composant ou partie de composant (26A, 26B), comportant :
- des étapes de préparation selon lesquelles on réalise sur de premier et second supports (21A, 21 B) de première et seconde couches rapportées (22A, 22B) dont au moins une partie de chaque couche est apte à être localement fragilisée, chaque support et la partie fragilisable associée étant en des matériaux différents et/ou ayant des microstructures différentes,
- des étapes de fragilisation selon lesquelles on génère dans chaque partie fragilisable des sous-couches fragiles (25A, 25B) uniquement en regard des futurs composants ou parties de composant,
- des étapes de travail selon lesquelles on réalise sur ces couches rapportées des parties complémentaires d'une pluralité de composants ou de parties de composant (26A, 26B),
- une étape de liaison selon laquelle on assemble ces deux supports tête-bêche en sorte d'obtenir une couche mince comportant ces parties complémentaires, ces parties complémentaires de composant étant en regard, et
- des étapes de séparation, dont une partie peut avoir lieu entre les étapes de fragilisation et l'étape de liaison, selon lesquelles on provoque une dissociation dans ces parties fragilisables, le long de ces sous-couches fragiles, en sorte de dissocier individuellement les composants ou parties de composant.

2. Procédé selon la revendication 1, **caractérisé en ce que** les étapes de séparation comportent une étape selon laquelle on transforme les sous-couches fragiles en zones de dissociation.

3. Procédé selon la revendication 1, **caractérisé en ce que** les étapes de séparation comportent, avant l'étape de liaison, une étape selon laquelle on transforme les sous-couches fragiles en zones de dissociation.

4. Procédé selon l'une quelconque des revendications 1 à 3, **caractérisé en ce que**, lors des étapes de travail, une pluralité de composants ou de parties de composant est réalisée et, lors de l'étape de séparation, chaque composant ou partie de composant est fixé individuellement à un support final, en étant détaché du reste de la couche mince.

5. Procédé selon l'une quelconque des revendications 2 à 4, **caractérisé en ce que** l'on dissocie individuellement les composants ou les parties de composant par découpes de l'un des supports transversalement à la couche mince.

6. Procédé selon l'une quelconque des revendications 1 à 5, **caractérisé par** une étape selon laquelle on fixe au moins une partie de la couche mince à un support final, par collage ou adhésion moléculaire.

7. Procédé selon la revendication 4 ou la revendication 6, **caractérisé en ce que** le support final est en un matériau différent de celui du support.

## Claims

1. Method for producing a thin layer incorporating at least one component or component part (26A, 26B), comprising:
- preparation steps according to which first and second added layers (22A, 22B) are made on first and second substrates (21A, 21B), of which at least a part of each layer can be locally weakened, each substrate and the associated part able to be weakened being made from different materials and/or having different microstructures,
- weakening steps according to which fragile sub-layers (25A, 25B) are created in each part able to be weakened facing the future components or component parts only,
- work steps according to which complementary parts of a plurality of components or component parts (26A, 26B) are made on these added layers,
- a joining step according to which these two substrates are assembled head to tail in order to obtain a thin layer incorporating these complementary parts, these complementary parts of the component facing one another and
- separation steps, part of which may take place between the weakening steps and the joining step, according to which a detachment is induced in these weakened parts along these fragile sub-layers, in order to individually detach the components or the component parts.

2. Method according to claim 1, **characterised in that** the separation steps comprise a step according to which the fragile sub-layers are converted into detachment zones.

3. Method according to claim 1, **characterised in that** the separation steps include, prior to the joining step, a step according to which the fragile sub-layers are converted into detachment zones.

4. Method according to any one of claims 1 to 3, **characterised in that** a plurality of components or component parts is made during the work steps and, during the separation step, each component or component part is individually affixed to a final support, having been detached from the rest of the thin layer.

5. Method according to any one of claims 2 to 4, **characterised in that** the components or component parts are detached individually by cutting one of the substrates transversely to the thin layer.

6. Method according to any one of claims 1 to 5, **characterised by** a step according to which at least a part of the thin layer is affixed to a final substrate by gluing or molecular adhesion.

7. Method according to claim 4 or claim 6, **characterised in that** the final substrate is made from a different material than that of the initial substrate.

## Patentansprüche

1. Verfahren zur Herstellung einer Dünnschicht, die mindestens eine Komponente oder einen Komponententeil (26A, 26B) umfasst, umfassend:
- Herstellungsschritte, in welchen man auf einem ersten und einem zweiten Träger (21A, 21B) eine erste und eine zweite angebrachte Schicht (22A, 22B) herstellt, von denen mindestens ein Teil jeder Schicht in der Lage ist, örtlich fragilisiert zu werden, wobei jeder Träger und der zugeordnete fragilisierbare Teil aus Werkstoffen bestehen, die verschieden sind und/oder verschiedene Mikrostrukturen aufweisen,
- Fragilisierungsschritte, in welchen man in jedem fragilisierbaren Teil fragile Unterschichten (25A, 25B) nur gegenüber den zukünftigen Komponenten oder Komponententeilen erzeugt,
- Arbeitsschritte, in denen man auf diesen angebrachten Schichten ergänzende Teile einer Mehrzahl von Komponenten oder Komponententeilen (26A, 26B) herstellt,
- einen Verbindungsschritt, in dem man diese beiden Träger umgekehrt zu einander so zusammenfügt, dass man eine diese ergänzenden Teile umfassende Dünnschicht erhält, wobei diese ergänzenden Komponententeile einander zugewandt sind, und
- Trennschritte, von denen ein Teil wischen den Fragilisierungsschritten und dem Verbindungsschritt stattfinden kann und in denen man in diesen fragilisierbaren Teilen längs der fragilen Unterschichten eine Abtrennung bewirkt, so dass die Komponenten oder Komponententeile einzeln abgetrennt werden.

2. Verfahren nach Anspruch 1, **dadurch gekennzeichnet, dass** die Trennschnitte einen Schritt umfassen, in dem man die fragilen Unterschichten in Abtrennungszonen umwandelt.

3. Verfahren nach Anspruch 1, **dadurch gekennzeichnet, dass** die Trennschritte vor dem Verbindungsschritt einen Schritt umfassen, in dem man die fragilen Unterschichten in Abtrennungszonen umwandelt.

4. Verfahren nach einem der Ansprüche 1 bis 3, **dadurch gekennzeichnet, dass** in Arbeitsschritten eine Mehrzahl von Komponenten oder Komponententeilen hergestellt wird und in dem Trennschnitt jede Komponente oder jeder Komponententeil einzeln an einem endgültigen Träger befestigt wird, indem sie bzw. er vom Rest der Dünnschicht abgelöst wird.

5. Verfahren nach einem der Ansprüche 2 bis 4, **dadurch gekennzeichnet, dass** man die Komponenten oder die Komponententeile einzeln durch Schnitte eines der Träger quer zur Dünnschicht abtrennt.

6. Verfahren nach einem der Ansprüche 1 bis 5, **gekennzeichnet durch** einen Schritt, in dem man mindestens einen Teil der Dünnschicht durch Verkleben oder molekulare Adhäsion an einem endgültigen Träger befestigt.

7. Verfahren nach Anspruch 4 oder Anspruch 6, **dadurch gekennzeichnet, dass** der endgültige Träger aus einem anderen Werkstoff als der Träger besteht.
